# EUROPEAN PATENT SPECIFICATION

(11) **EP 1 078 467 B1**
(45) Date of publication and mention of the grant of the patent: **04.04.2007**
(21) Application number: 99927747.8
(22) Date of filing: 21.05.1999
(51) Int. Cl.: H03L 7/099, H03L 7/10, H03L 7/183, H04B 1/40

(54) **MULTIBAND FREQUENCY GENERATION USING A SINGLE PLL-CIRCUIT**
MEHRFACHBAND-FREQUENZGENERIERUNG MIT EINER EINZIGEN PLL-SCHALTUNG
GENERATION DE FREQUENCES MULTIBANDE AU MOYEN D'UN CIRCUIT PLL UNIQUE

(30) Priority: 22.05.1998 DE 19823103
(43) Date of publication of application: 28.02.2001
(73) Proprietor: TELEFONAKTIEBOLAGET LM ERICSSON (publ), 164 83 Stockholm (SE)
(72) Inventor: RIES, Christian, D-90441 Nuremberg (DE)
(74) Representative: HOFFMANN EITLE
(86) International application number: PCT/EP1999/003529
(87) International publication number: WO 1999/062178

(56) References cited:
- EP-A- 0 206 247
- WO-A-98/17012
- WO-A-98/51014
- FR-A- 2 685 583
- GB-A- 2 310 342
- PATENT ABSTRACTS OF JAPAN vol. 1997, no. 11, 28 November 1997 (1997-11-28) & JP 09 186587 A (KENWOOD CORP), 15 July 1997 (1997-07-15)

## Description

The present invention relates to a multiband frequency generator according to the preamble of claim 1 and a related method to operate the same according to the preamble of claim 19. Also, the present invention relates to a sending/receiving unit for a mobile radio unit according to the preamble of claim 14.

From FR-A-2 685 583 there is known a multiband frequency generator comprising a voltage controlled multiband oscillator, a frequency synthesis means and a control means for the voltage controlled multiband oscillator using the phase difference generated through the frequency synthesis means as correcting variable. The coupling between voltage controlled multiband oscillator and frequency synthesis means is achieved using diodes.

Further, from EP-A-206 247 there is known a PLL frequency synthesizer comprising a reference oscillator, a frequency divider, a phase comparator for phase-comparing the output of the reference oscillator with the output of the frequency divider, and first and second loop filters coupled to the output of the phase comparator. Here, a switch selectively supplies output signals of first and second voltage controlled oscillators to the input of the frequency divider in response to a control signal.

Still further, from WO98/17012 there is known a dual-mode radiotelephone capable of operating in the analog or digital mode, respectively. A digital signal processor receives a speech signal to be transmitted in the digital or analog mode and generates In-phase and Quadrature modulating signals. The I and Q signals are supplied to a quadrature modulator for generating a digitally modulated signal. Also the I and Q signals are supplied to an analog modulator for generating an analog modulated signal.

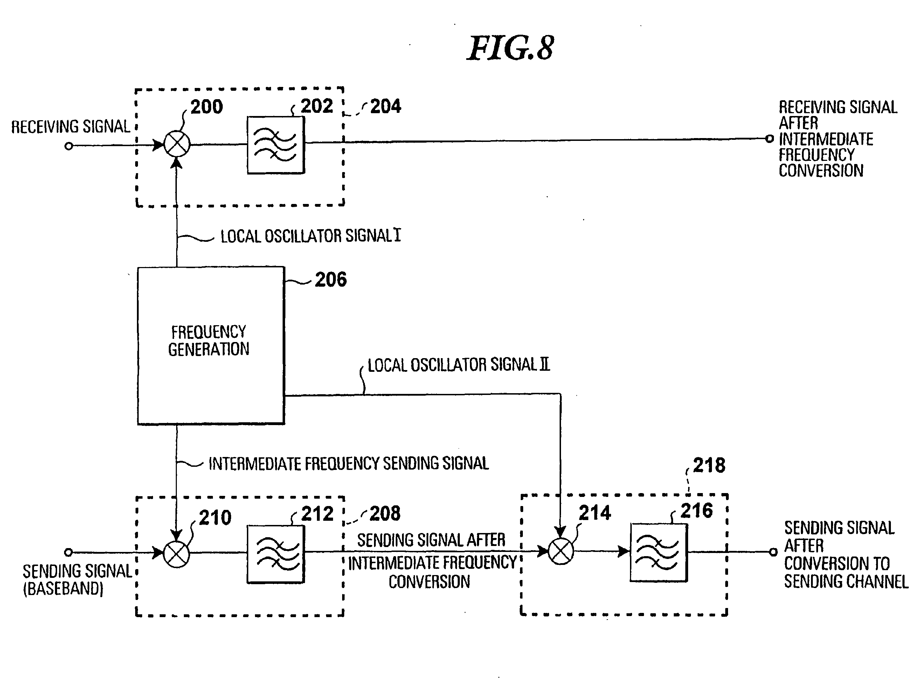

Fig. 8 shows a typical method for sending and receiving signals in mobile phones. In the receiving path, a first mixer stage 204 comprising a multiplier 200 and a band pass filter 202 is supplied with a local oscillator signal outputted through a frequency generator 206 such that at the output of the mixer stage 204 the receiving signal is available according to a fixed intermediate frequency (IF) for the further processing in downstream circuit unit (not shown).

As also shown in Fig. 8, when sending a modulated sending signal (provided in the base-band) this sending signal is converted to an intermediate frequency-band specified through a sending intermediate frequency signal using a second mixer stage 208 with a second multiplier 210 and a second band-pass 212. Then, the conversion to the sending channel is executed through a third mixer stage 218 comprising a third multiplier 214 and a third band-pass filter 216.

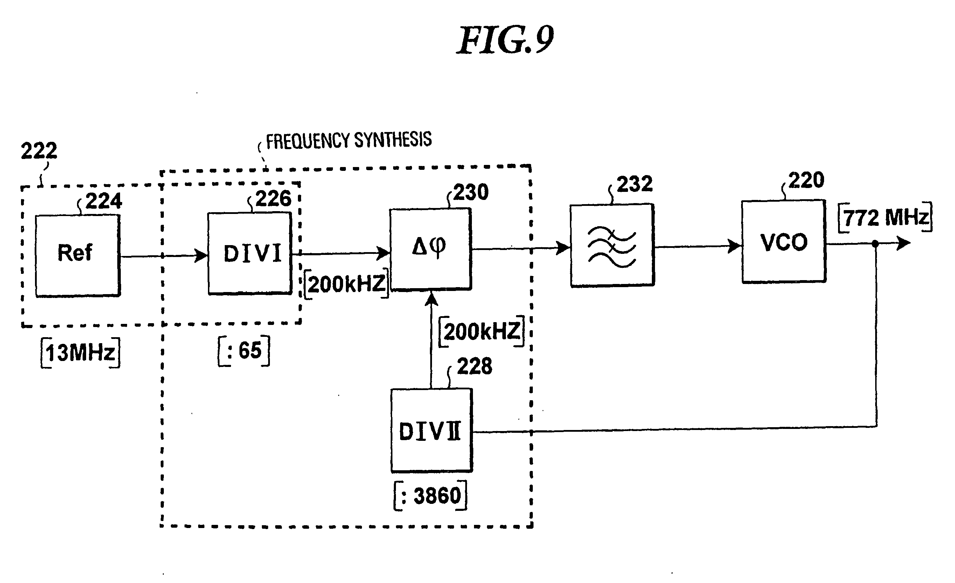

Fig. 9 shows a detailed schematic diagram for the frequency generation unit 206. Here, the object is to tune the frequency of a voltage-controlled oscillator 220 such that it is coincident to a frequency of a basic oscillator 222 multiplied with a dividing factor of a second programmer divider 228. In Fig. 9, specific numerical values are given for a GSM-application example in square brackets.

The basic oscillator 222 comprises a reference oscillator 224 and in addition a first programmable divider 226 to variably pre-specify a reference frequency. A second programmable divider 228 is provided to convert the frequency generated by the voltage-controlled oscillator 222 into the pre-specified reference frequency outputted by the basic oscillator 222.

A phase detector 230 enables a comparison of the sending signal converted with the second programmable divider 228 and the reference signal outputted through the first programmable divider 226. The phase error between the divided reference signal and the divided output signal of the voltage-controlled oscillator 220 determined by the phase detector 230 is supplied to a loop filter 232 where an integration takes place.

Using this integrated error signal, the voltage-controlled oscillator 220 is controlled until there exists no further frequency and phase difference, respectively, between the signals used for comparison. Herethrough, the voltage-controlled oscillator 220 has a relative stability that is identical to the relative stability of the basic oscillator 222. For the example shown in Fig. 9, e.g., in case the relative stability of the basic oscillator is (1 Hz)/ (200 kHz) the relative stability for the voltage-controlled oscillator 220 is (3860 Hz)/(772 Mhz).

For applications such as GSM 900, GSM 1800 or PCS-mobile telephony, the tuning of the receiving or sending channel is carried out through determination of the divider ratio for the first and second programmable divider 226 and 228, respectively. Therefore, the voltage-controlled oscillator 220 may easily be tuned to different sending frequencies within a stable operation. Here, the adjustment behaviour and the stability is essentially determined through the design of the loop filter 232.

The design shown in Fig. 9 is suitable for mobile phones being operated in one frequency band. However, this single-band operation is no longer suitable in view of the increasing number of subscribers and the limited number of sending frequencies in existing cellular mobile networks.

To the contrary, a combination of technical advantages being related to different approaches seems to be promising, in particular through providing multiband cellular networks and multiband mobile phones being related thereto, e.g., through combining the GSM 900, GSM 1800 and PCS frequency bands.

However, a prerequisite to this approach is the frequency generation for the respective frequency bands while simultaneously meeting the strict requirements explained with respect to Figs. 8 and 9. For a dual band operation two frequency generators will be required for the two frequency bands. However, it is not possible to use only a single voltage-controlled oscillator since the tuning range that will be necessary in case of a single voltage-controlled oscillator would lead to an influence of noise onto the system that is too large and therefore to a violation of pre-defined specifications. Therefore, two voltage-controlled oscillators operating independently should be provided for the dual band operation mode.

The direct generalization of the approach explained with reference to Fig. 9 would be a duplication of the components according to the number of pre-specified frequency bands. While this allows to provide frequency signals in an independent manner through related phase-locked loop circuits, this may only be achieved with significant additional circuitry and additional costs. Further, increased space requirements constitute a barrier against this approach, since a plurality of frequency synthesis units are necessary, e.g., in the form of a plurality of integrated circuits.

In view of the above, the object of the present invention is to provide a multiband frequency generator with minimized circuitry requirements and a method of operating a multiband frequency generator.

According to the present invention, this object is achieved through a multiband frequency generator to generate an output signal in at least two frequency bands having the features of claim 1 and through a method as defined in claim 19. The multiband frequency generator comprises a voltage-controlled multiband oscillator to generate an output signal in each frequency band at one output for each frequency band, a frequency synthesis means to derive a phase difference between a control input signal for the frequency and the generated output signal, at least one control means for the voltage-controlled multiband oscillator using the phase difference generated through said frequency synthesis means as correcting or manipulating variable, respectively, wherein each output terminal of said multiband oscillator is coupled to the frequency synthesis means via a frequency selective coupling means consisting of a filter bank adapted to achieve a decoupling of the different multiband output signals through a frequency selective behaviour of said filter bank before feedback to the frequency synthesis means.

Therefore, according to the present invention, only a single frequency synthesis means must be used since different output branches of the multiband frequency generator are always coupled to the same frequency synthesis means in a frequency selective way. The frequency selective behaviour of the coupling unit enables an excellent decoupling of the different single oscillator units of the voltage-controlled multiband oscillator.

Further, the invention enables a low loss between the different oscillator units of the voltage-controlled multiband oscillator and the phase-locked loop circuit comprising the frequency synthesis means and the control means.

Still further, the frequency selective coupling means also enables an impedance matching between the oscillator units of the voltage-controlled multiband oscillator and the phase-locked loop circuit and in addition a DC-decoupling.

According to a further preferred embodiment of the present invention, a control means is provided for each frequency band.

The provision of a single control means for each frequency band enables the individual determination of the adjustment behaviour and the stability of the different voltage-controlled oscillators.

According to a further preferred embodiment of the present invention, the voltage-controlled multiband oscillator comprises a plurality of voltage-controlled single band oscillators connected in parallel. Alternatively, there may be provided a switchable voltage-controlled oscillator. Both approaches enable the flexible handling of pre-defined specifications in that the number of voltage-controlled single band oscillators and switching stages of the switchable voltage-controlled oscillator, respectively, is adjusted to the number of frequency bands that must be generated.

Since the frequency selective coupling means comprises a filter bank, the decoupling and impedance matching may be optimized in a scalable manner in dependence of the number of pre-specified frequency bands and also in dependence of the specifications to be fulfilled.

Overall, the present invention enables the multiband-frequency generation with only a single PLL-circuit while using only a single frequency synthesis means through switching the supply voltage between the oscillator units of the voltage-controlled multiband oscillator and also through frequency selective coupling of the output signal at the phase-locked loop circuit.

Preferred embodiments of the present invention will be described in the following under reference to the enclosed drawings in which:
- Fig. 1: shows a schematic diagram of a first embodiment of the multiband frequency generator according to the present invention;
- Fig. 2: shows a schematic diagram of a second embodiment of the multiband frequency generator according to the present invention;
- Fig. 3: shows a schematic diagram of the frequency selective coupling unit according to the present invention;
- Fig. 4: shows a circuit diagram of the frequency selective coupling unit shown in Fig. 2;
- Fig. 5: shows the principles for a sending/receiving operation mode using the multiband-frequency generator according to the present invention;
- Fig. 6: shows a schematic diagram for the sending/receiving operation using the multiband frequency generator according to the present invention, wherein the sending and receiving is executed in a plurality of frequency bands while using a common loop filter for all sending branches;
- Fig. 7: shows a schematic diagram for the sending/receiving operation using the multiband frequency generator according to the present invention, wherein the sending and receiving is executed in a plurality of frequency bands while using a loop filter for every sending branch;
- Fig. 8: shows a schematic diagram according to the intermediate frequency conversion for sending and receiving signals;
- Fig. 9: shows the mode of operation for a follow-up synchronization with a single PLL-circuit.

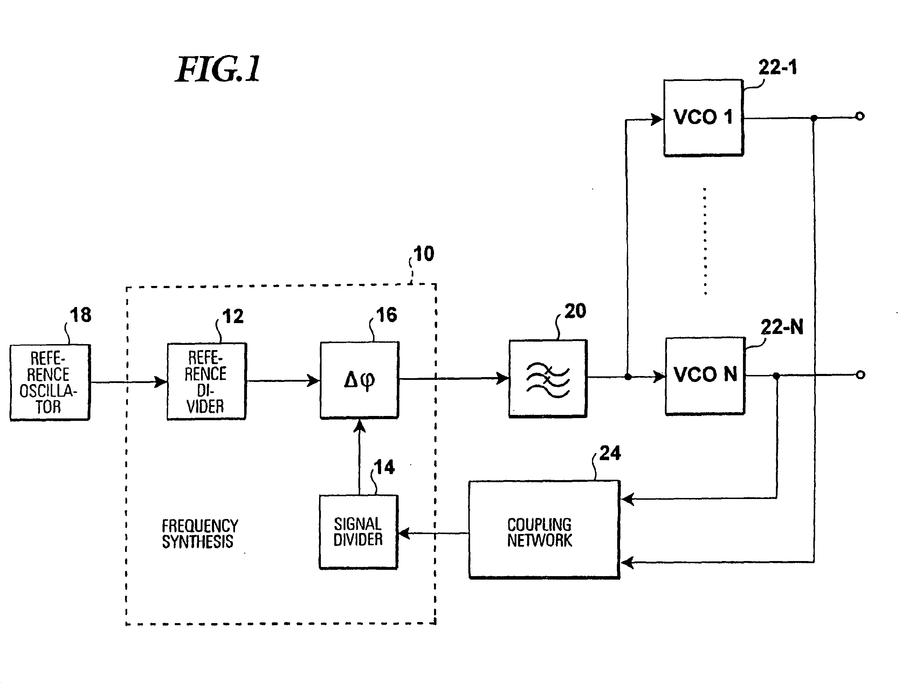

As shown in Fig. 1, the multiband frequency generator according to the present invention comprises only one frequency synthesis unit 10. The frequency synthesis unit 10 comprises a programmable reference divider 10, a programmable signal divider 14 and a phase detector 16. The input to the programmable reference divider 12 is connected to a reference oscillator 18. Further, the output terminal of the programmable reference divider 12 and the output terminal of the programmable signal divider 14 are connected to the input terminals of the phase detector 16, respectively.

As also shown in Fig. 1, according to the first embodiment of the present invention the output terminal of the phase detector 16 is connected to the input terminal of a loop filter 20 provided for all frequency bands in common such that the output signal of the loop filter 20 is supplied to the different voltage-controlled oscillators 22-1 to 22-N as correcting variable or equivalently as controller output. The output terminals of the voltage-controlled oscillator 22-1, ..., 22-N are connected to the input terminal of the programmable signal divider 14 in the frequency synthesis unit 10 via a coupling network 24.

During operation of the multiband frequency generator according to the present invention the frequency band is determined on the one hand through the selection of the power supply for the voltage-controlled oscillators 22-1, ..., 22-N and on the other hand through the programming of the programmable reference divider 12. Therefore, at every time one of the voltage-controlled oscillators 22-1, ..., 22-N outputs an output signal at a frequency which is controlled according to the frequency control input signal provided through the reference oscillator 18 and the programmable reference divider 12.

Heretofore, the output signal of the coupling network 24 is forwarded to the second programmable signal divider 14 adapted through appropriate programming to re-convert the output signal of the activated voltage-controlled oscillator 22-1, ..., 22-N into the range of the frequency control input signal. Then, the phase detector 16 derives the phase difference between the frequency control input signal at the output of the programmable reference divider 12 and the output signal of the programmable signal divider 14.

This phase difference is then supplied to a loop filter 20 with integrating characteristics. The output signal of this loop filter 20 is used to control the activated voltage-controlled oscillator 22-1, ..., 22-N such that the phase difference at the output of the phase detector 10 is at least constant, i.e. the frequency of the output signal of the activated voltage-controlled oscillator 22-1, ..., 22-N after division through the programmable signal divider 14 is coincident to the frequency of the frequency control input signal.

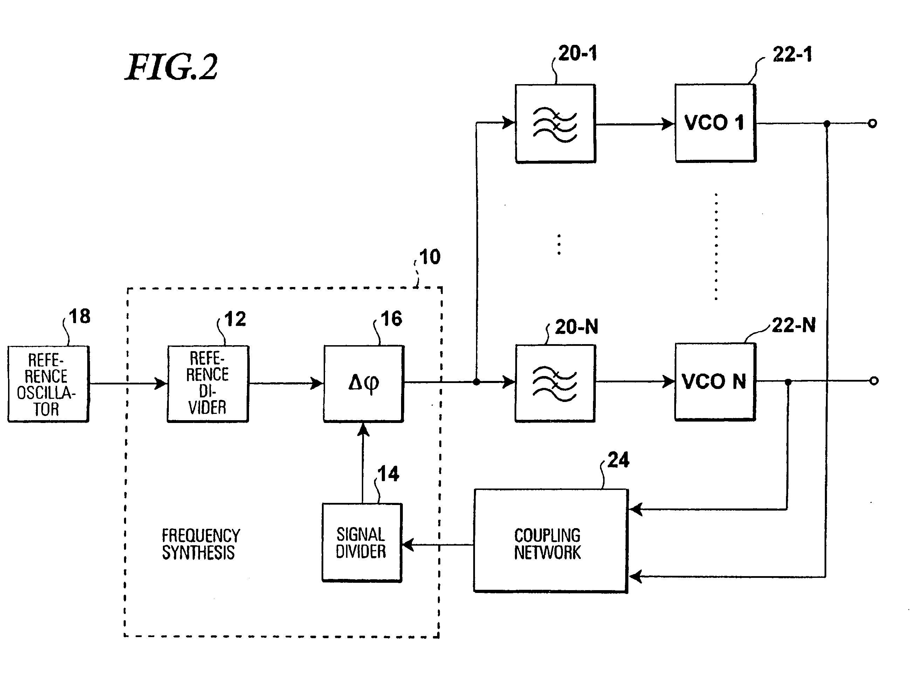

Fig. 2 shows a schematic diagram of a second embodiment of the multiband frequency generator. In Fig. 2, circuit components having a functionality being identical to that of components shown in Fig. 1 are denoted using the same reference numerals.

As shown in Fig. 2, according to the second embodiment of the present invention for each voltage-controlled oscillator 22-1, ..., 22-N there is provided a dedicated loop filter 20-1, ..., 20-N.

To process the phase difference in a frequency selective way this phase difference is supplied to a loop filter 20-1, ..., 20-N specifically provided for each frequency band. The output signal of each loop filter 20-1, ..., 20-N is then used to control the related voltage-controlled oscillator 22-1, ..., 22-N such that the frequency resulting from a division of the output signal frequency of the related voltage-controlled oscillator 22-1, ..., 22-N is coincident to the frequency control input signal.

Therefore, the second embodiment of the present invention enables a specific tuning of the transient behaviour and the stability of each voltage-controlled oscillator.

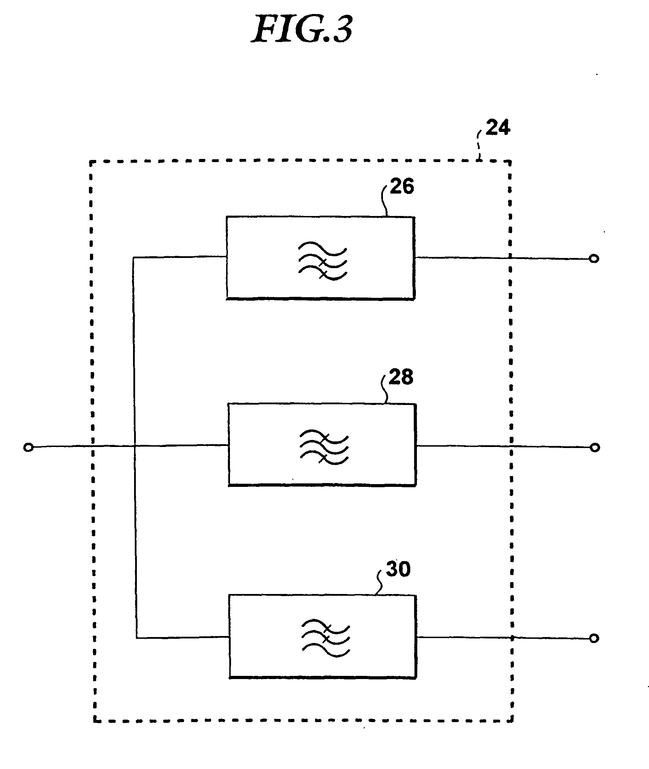

Fig. 3 shows a schematic diagram of the coupling network 24 shown in Fig. 1. This coupling network 24 is implemented as filter bank and comprises at least two elements taken from a group consisting of a high pass filter 26, a band pass filter 28 and a low pass filter 30.

Operatively, the coupling network 24 and the filter component comprised therein achieves an effective decoupling between the different voltage-controlled oscillator units 22-1, ..., 22-N of the voltage-controlled multiband oscillator, both, for the first and second embodiment of the present invention. Further, operatively the coupling network 24 enables an impedance matching between different voltage-controlled oscillators 22-1, ..., 22-N and the input impedance of the programmable signal divider 14. Further, through appropriate design the loss between each voltage-controlled oscillator 22-1, ..., 22-N and the phase-locked loop circuit consisting of the frequency synthesis unit 10 and the loop filter 20 is minimized.

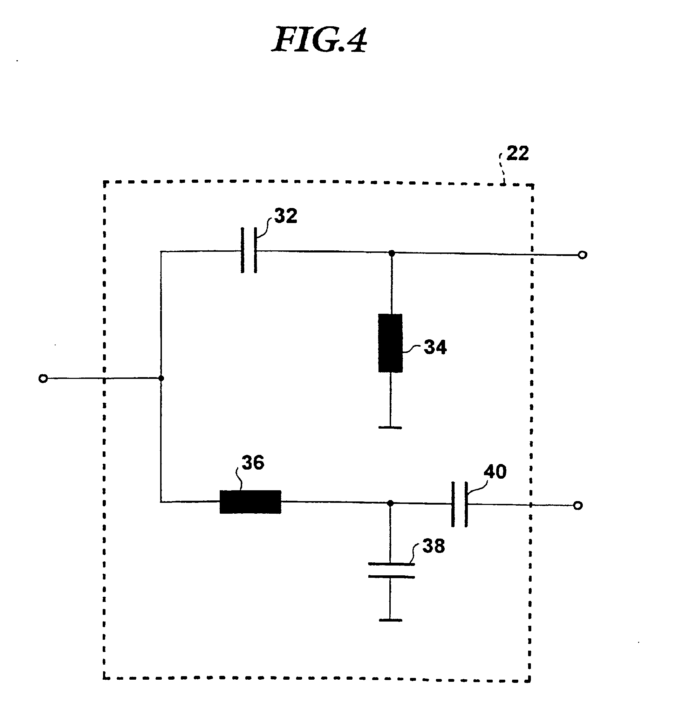

Fig. 4 shows a specific implementation of the coupling network 24 for a dual band operation. This coupling network 24 comprises a high pass filter and a low pass filter.

As shown in Fig. 4, the high pass filter consists of a first capacitor 32 connected in series and a first inductivity 34 connected thereto in parallel. The low pass filter consists of an inductivity 36 connected in series and a second capacitor 38 connected in parallel. At a branch point between the second inductivity 36 and the second capacitor 38 there is connected a third capacitor 40 in series. The cutoff frequency of the high pass filter with the first capacitor 32 and the first inductivity 34 lies above the signal frequency of the voltage-controlled oscillator in the lower frequency band.

Operatively, the first capacitor 32 shortcuts signals in the higher frequency range while signal components of lower frequency are branched off through the first inductivity 34. Further, the first capacitor 32 and the first inductivity 34 enable an impedance matching between the related voltage-controlled oscillator and the input terminal of the programmable signal divider 14.

Further, the second inductivity 36 shown in Fig. 4 forwards signal components with lower frequencies to the programmable signal divider 14 while signal components in the higher frequency ranges are shortcut through the second capacitor 38 to ground. The third capacitor 40 is provided for a DC-decoupling. Further, the second inductivity 36 and the second capacitor 38 also enable an impedance matching between the related voltage-controlled oscillator and the input terminal of the programmable signal divider 14.

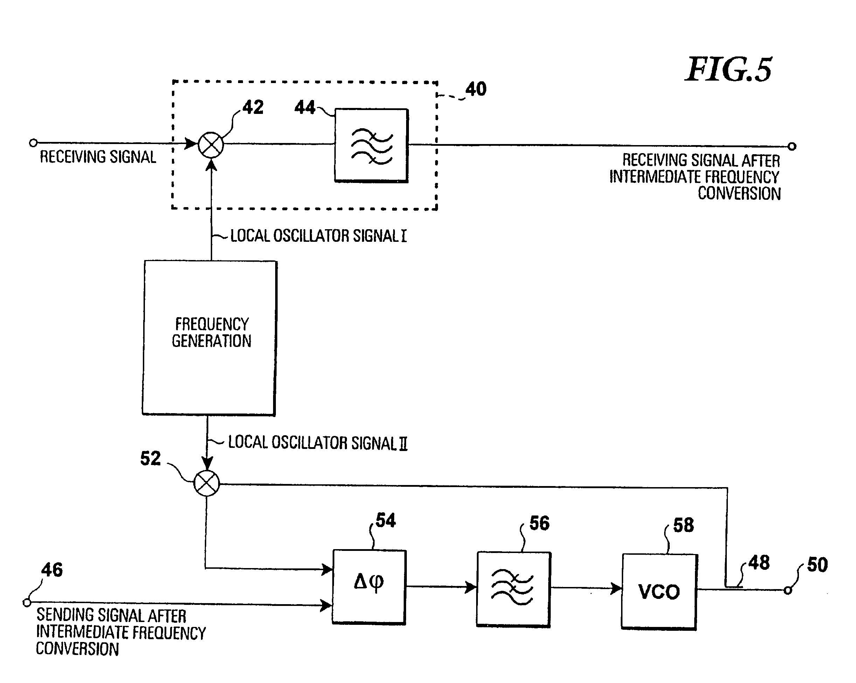

Fig. 5 shows the basic principle underlying the application of the multiband frequency generator according to the present invention.

As shown in Fig. 5, a local oscillator signal is generated in a frequency generator and this local oscillator signal is used in a mixer stage 40 comprising a multiplier 42 and a band pass 44 for the conversion of the receiving signal in a receiving intermediate frequency range. In this respect the approach is similar to the approach explained with reference to Fig. 8 that is also related to the intermediate frequency conversion of a receiving signal.

However, as is shown in Fig. 5, the conversion in the sending channel is implemented in a completely different way. At a sending terminal 46 an intermediate frequency modulated sending signal is supplied. At the same time a sending signal outputted via a sending output terminal 50 is supplied to a re-convert multiplier 52 via a tap 48. Here, the re-convert multiplier 52 serves to re-convert the sending signal into the intermediate frequency band. A sending phase detector determines the phase difference between the IF-re-converted sending signal and the IF-modulated sending signal and at the same time implements a filtering of those signal components comprised in the IF-re-converted sending signal which are to be suppressed for the further processing.

Using the phase difference available at the output terminal of the sending phase detector 54, a voltage-controlled sending oscillator 58 is controlled via a loop filter 56 such that the phase difference between the IF-re-converted sending signal and the IF-modulated sending signal is used as a correcting variable, or in other words, the IF-modulated sending signal is impressed onto the output signal of the voltage-controlled sending oscillator 58.

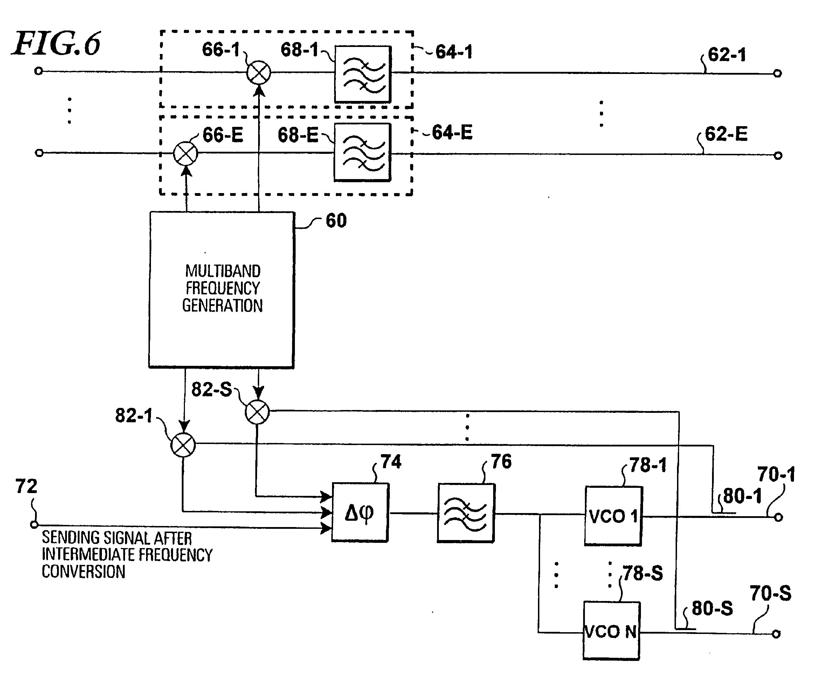

Fig. 6 shows a first application of the multiband-frequency generator according to the present invention in a sending/ receiving unit being operated in accordance to the functional diagram explained above with respect to Fig. 5.

As shown in Fig. 6, a multiband-frequency generator 60 according to the first and second embodiment, respectively, is connected to a plurality of receiving channels 62-1, ..., 62-E. In each receiving channel 62-1, ..., 62-E there is provided a related mixing stage 64-1, ..., 64-E each comprising a multiplier 66-1, ..., 66-E and a band-pass filter 68-1, ..., 68-E, respectively. Operatively, to each receiving channel there is supplied a suitable local oscillator signal through the multiband frequency generator 60 in accordance with the respective frequency band.

As also shown in Fig. 6, there is also provided a plurality of sending channels 70-1, ..., 70-S. A sending terminal 72 is provided to supply an IF-modulated sending signal which is directed towards one input terminal of a multiband sending phase detector 74 processing the IF-modulated sending signal and an IF-re-converted sending signal at every time. The output signal of this multiband sending phase detector 74 is supplied via a multiband loop filter to each of a plurality of voltage-controlled oscillators 78-1, ..., 78-S provided for the different sending frequency bands. At the output terminal of each such voltage-controlled oscillator 78-1, ..., 78-S, the related output signal is picked up with a tap 80-1, ..., 80-S to the related IF-re-conversion-multiplier 82-1, ..., 82-S provided for a re-conversion of the sending signal into the IF-frequency-band, respectively.

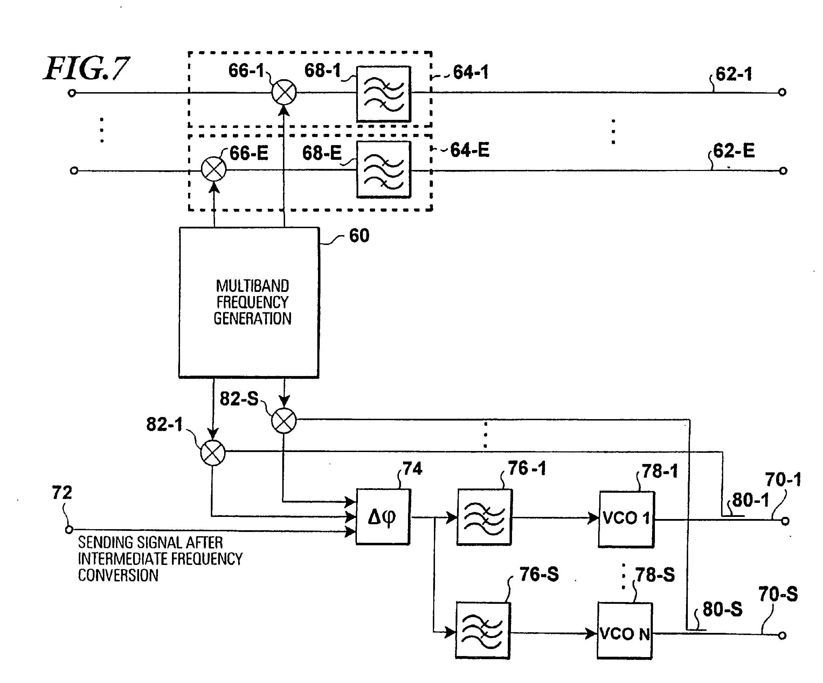

Fig. 7 shows a second application of the multiband frequency generator according to the present invention within a sending/ receiving unit in accordance with the basic functional principle outlined above with reference to Fig. 5. Here, circuit components having the same functionality as those shown in Fig. 6 are denoted with the same reference numerals.

The second application of the multiband frequency generator according to the present invention differs from the first application explained above with reference to Fig. 6 in that there is provided a single loop filter 76-1, ..., 76-S in each sending branch 70-1, ..., 70-S to control the related voltage-controlled oscillator 78-1, ..., 78-S. Therefore, the transient behaviour and the related stability in each sending channel 70-1, ..., 70-S may be controlled and varied selectively.

Since the mode of operation for every single sending branch is identical to the mode of operation explained above with reference to Fig. 5, both for the first and second generation mode of the multiband-frequency generator it will not be explained here. Contrary to the single band operation the stable and precise provision of the different local oscillator signals for the receiving channels 62-1, ..., 62-E and the sending channels 72-1, ..., 72-S, respectively, is a prerequisite for a stable and reliable sending reception in the multiband operation. Further, the impression of a phase difference between an IF-re-converted sending signal and the related IF-reference signal onto the related voltage-controlled sending oscillator leads to a very efficient and circuitry minimizing realization of the sending operation in the multiband mode as - contrary to the approach explained with reference to Fig. 8 - it is not necessary to provide a single band pass filter for each sending channel 72-1, ..., 72-S.

## Claims

1. Multiband frequency generator to generate an output signal in at least two frequency bands, comprising:
a) voltage-controlled multiband oscillator (22-1, ... , 22-N) to generate an output signal in each frequency band at one output terminal for each frequency band,
b) a frequency synthesis means (10) to derive a phase difference between a control input signal for the frequency and the generated output signal,
c) at least one control means (20) for the voltage-controlled multiband oscillator using the phase difference generated through said frequency synthesis means (10) as correcting variable, respectively,
**characterized in that**
d) each output terminal of said multiband oscillator is coupled to the frequency synthesis means (10) via a frequency selective coupling means (24) consisting of a filter bank adapted to achieve a decoupling of the different multiband oscillator output signals through a frequency selective behaviour of said filter bank before feedback to the frequency synthesis means (10).

2. Multiband frequency generator according to claim 1, **characterized in that** there is provided a dedicated control means (20-1, ..., 20-N) for each frequency band.

3. Multiband frequency generator according to one of the claims 1 and 2, **characterized in that** the frequency synthesis means (10) comprises:
e) a first programmable reference divider (12) to derive the control input signal by dividing the frequency of a prespecified reference signal,
f) a second programmable signal divider (14) to divide the frequency of the output signal of the frequency selective coupling means (24) via a predefined factor, and
g) a phase difference detector means (16) to derive the phase difference between the output signal of the first programmable reference divider (12) and the output signal of the second programmable signal divider (14).

4. Multiband frequency generator according to one of the claims 1 or 3, **characterized in that** the control means (20) for the voltage-controlled multiband oscillator is a loop filter.

5. Multiband frequency generator according to claim 2 or 3, **characterized in that** each control means (20-1, ..., 20-N) for the voltage-controlled multiband frequency oscillator is a loop filter.

6. Multiband frequency generator according to one of the claims 1 to 5, **characterized in that** the voltage-controlled multiband oscillator consists of a plurality of voltage-controlled single band oscillators (22-1, ..., 22-N) connected in parallel.

7. Multiband frequency generator according to one of the claims 1 to 6, **characterized in that** the voltage-controlled multiband oscillator is a switchable voltage-controlled oscillator.

8. Multiband frequency generator according to one of the claims 1 to 7, **characterized in that** the filter bank comprises at least a low pass filter (30).

9. Multiband frequency generator according to claim 8, **characterized in that** the filter bank comprises at least a band pass filter (28).

10. Multiband frequency generator according to claim 8 or 9, **characterized in that** the filter bank comprises at least a high pass filter (26).

11. Multiband frequency generator according to one of the claims 8 to 10, **characterized in that** the low pass filter comprises a first inductivity (36) connected in series between the input terminal of the low pass filter and the output terminal of the low pass filter and a first capacitor (38) branches off to ground before the first inductivity (36).

12. Multiband frequency generator according to claim 11, **characterized in that** in the low pass filter a second capacitor (40) is connected in series between the first inductivity (36) and the input terminal of the low pass filter.

13. Multiband frequency generator according to one of the claims 10 to 12, **characterized in that** the high pass filter (26) comprises a third capacitor (32) connected in series between the input terminal of the high pass filter and the output terminal of the high pass filter and a second inductivity (34) branches off to ground before the third capacitor (32).

14. Sending/receiving unit for a mobile radio unit with multiband operation, comprising:
a) at least one receiving branch (62-1, ... ,62-E) for each receiving frequency band with a mixer stage, whereto a first local oscillator signal is supplied in a suitable manner,
b) at least one transmitting branch (70-1, ..., 70-S) for each transmitting frequency band in which an intermediate frequency modulated sending signal is converted into the sending frequency band,
**characterized in that**
c) the conversion into the sending frequency band is achieved through a phase comparison of the intermediate frequency modulated sending signal with a sending signal re-converted into an intermediate frequency band and through control of a voltage-controlled oscillator (78-1, ..., 78-S) in accordance with the phase difference, and
d) a multiband frequency generator according to one of the claims 1 to 13 is issued to generate the local oscillator signals.

15. Sending/receiving unit according to claim 14 **characterized in that** the transmitting branch for each transmitting frequency band comprises:
e) a phase detector (74) to generate the frequency difference between the intermediate frequency modulated sending signal and the sending signal re-converted into the intermediate frequency at the output of the transmitting branch, and
f) a loop filter (76) to supply the phase difference generated through the phase comparison to the voltage-controlled oscillator of the transmitting branch.

16. Sending / receiving unit according to claim 15, **characterized in that** the phase detector and the loop filter for each transmitting branch are common to each transmitting branch.

17. Sending/receiving unit according to claim 15 **characterized in that** there is provided a loop filter (76-1, ..., 76-S) for each transmitting branch.

18. Sending/receiving unit according to one of the claims 14 to 17, **characterized in that** there is provided a multiplication means (82-1, ..., 82-S) in each transmitting branch to re-convert the output signal of different sending channels through multiplication with a related second local oscillator signal.

19. Method of operating a multiband frequency generator to generate an output signal in at least two frequency bands, comprising the steps of :
a) outputting the output signal via one output of a voltage-controlled multiband oscillator (22-1, ..., 22-N) for each frequency band,
b) deriving a phase difference between a frequency control input signal and the generated output signal in a frequency synthesis means (10),
c) controlling the voltage-controlled multiband oscillator (22-1, ..., 22-N) using the phase difference as correcting variable,
**characterized in that** it further comprises the step of:
d) coupling the output signal at the output terminal of the voltage-controlled multiband oscillator (22-1, ..., 22-N) via a frequency selective coupling means (24) consisting of a filter bank adapted to achieve a decoupling of the different multiband output signals through a frequency selective behaviour of said filter bank before feedback to the frequency synthesis means (10).

20. Method according to claim 19, **characterized in that** the selection of the frequency band is achieved through switching on and off, respectively, a related unit in the voltage-controlled multiband oscillator (22-1, ..., 22-N) and further through suitable definition of the frequency control input signal.

## Patentansprüche

1. Ein Multibandfrequenzgenerator, um ein Ausgangssignal in mindestens zwei Frequenzbändern zu erzeugen, der beinhaltet:
a) einen spannungsgesteuerten Multibandoszillator (22-1, ..., 22-N), um ein Ausgangssignal in jedem Frequenzband an einem einzigen Ausgangsanschluss für jedes Frequenzband zu erzeugen,
b) eine Frequenzsyntheseeinrichtung (10), um einen Phasenunterschied zwischen einem Steuereingangssignal für die Frequenz und dem erzeugten Ausgangssignal abzuleiten,
c) mindestens eine Steuereinrichtung (20) für den spannungsgesteuerten Multibandoszillator, die jeweils den Phasenunterschied als Korrekturvariable benutzt, der durch die Frequenzsyntheseeinrichtung (10) erzeugt wird,
**gekennzeichnet dadurch, dass**
d) jeder Ausgangsanschluss des Multibandoszillators an die Frequenzsyntheseeinrichtung (10) über eine frequenzselektive Kopplungseinrichtung (24), die aus einer Filterbank besteht, gekoppelt ist, die angepasst ist, eine Entkopplung der verschiedenen Ausgangssignale des Multibandoszillators durch ein frequenzselektives Verhalten der Filterbank vor der Rückführung zu der Frequenzsyntheseeinrichtung (10) zu erreichen.

2. Ein Multibandfrequenzgenerator gemäß Anspruch 1, **gekennzeichnet dadurch, dass** für jedes Frequenzband eine zugeordnete Steuereinrichtung (20-1, ...,20-N) vorgesehen ist.

3. Ein Multibandfrequenzgenerator gemäß einem der Ansprüche 1 und 2, **gekennzeichnet dadurch, dass** die Frequenzsyntheseeinrichtung (10) beinhaltet:
e) einen ersten, programmierbaren Referenzdividierer (12), um das Steuereingangssignal durch Teilen der Frequenz eines vorher festgelegten Referenzsignals abzuleiten,
f) einen zweiten, programmierbaren Signaldividierer (14), um die Frequenz des Ausgangssignals der frequenzselektiven Kopplungseinrichtung (24) durch einen zuvor definierten Faktor zu teilen, und
g) eine Einrichtung zum Detektieren des Phasenunterschiedes (16), um den Phasenunterschied zwischen dem Ausgangsignal des ersten, programinierbaren Referenzdividierers (12) und dem Ausgangssignal des zweiten, programmierbaren Signaldividierers (14) abzuleiten.

4. Ein Multibandfrequenzgenerator gemäß einem der Ansprüche 1 oder 3, **dadurch gekennzeichnet, dass** die Steuereinrichtung (20) für den spannungsgesteuerten Multibandoszillator ein Schleifenfilter ist.

5. Ein Multibandfrequenzgenerator gemäß den Ansprüchen 2 oder 3, **dadurch gekennzeichnet, dass** jede Steuereinrichtung (20-1, ..., 20-N) für den spannungsgesteuerten Multibandoszillator ein Schleifenfilter ist.

6. Ein Multibandfrequenzgenerator gemäß einem der Ansprüche von 1 bis 5, **dadurch gekennzeichnet, dass** der spannungsgesteuerte Multibandoszillator aus einer Vielzahl von spannungsgesteuerten Einzelbandoszillatoren (22-1, ..., 22-N) besteht, die parallel verbunden sind.

7. Ein Multibandfrequenzgenerator gemäß einem der Ansprüche 1 bis 6, **dadurch gekennzeichnet, dass** der spannungsgesteuerte Multibandoszillator ein schaltbarer, spannungsgesteuerter Oszillator ist.

8. Ein Multibandfrequenzgenerator gemäß einem der Ansprüche 1 bis 7, **dadurch gekennzeichnet, dass** die Filterbank mindestens einen Tiefpassfilter (30) enthält.

9. Ein Multibandfrequenzgenerator gemäß dem Anspruch 8, **dadurch gekennzeichnet, dass** die Filterbank mindestens einen Bandpassfilter (28) enthält.

10. Ein Multibandfrequenzgenerator gemäß dem Anspruch 8 oder 9, **dadurch gekennzeichnet, dass** die Filterbank mindestens einen Hochpassfilter (26) enthält.

11. Ein Multibandfrequenzgenerator gemäß einem der Ansprüche 8 bis 10, **dadurch gekennzeichnet, dass** der Tiefpassfilter eine erste Induktivität (36) beinhaltet, die in Serie zwischen dem Eingangsanschluss des Tiefpassfilters und dem Ausgangsanschluss des Tiefpassfilters verbunden ist und ein erster Kondensator (38) vor der ersten Induktivität (36) zur Masse abzweigt.

12. Ein Multibandfrequenzgenerator gemäß dem Anspruch 11, **dadurch gekennzeichnet, dass** in dem Tiefpassfilter ein zweiter Kondensator (40) in Serie zwischen der ersten Induktivität (36) und dem Eingangsanschluss des Tiefpassfilters verbunden ist.

13. Ein Multibandfrequenzgenerator gemäß einem der Ansprüche von 10 bis 12, **dadurch gekennzeichnet, dass** der Hochpassfilter (26) einen dritten Kondensator (32) enthält, der in Serie zwischen dem Eingangsanschluss des Hochpassfilters und dem Ausgangsanschluss des Hochpassfilters verbunden ist und eine zweite Induktivität (34) vor dem dritten Kondensator (32) zur Masse abzweigt.

14. Eine Sende/Empfangseinheit für eine mobile Radioeinheit mit Multibandbetrieb, die beinhaltet:
a) mindestens einen Empfangszweig (62-1, ..., 62-E) für jedes Empfangsfrequenzband mit einer Mixerstufe, zu dem ein erstes, lokales Oszillatorsignal in einer geeigneten Art und Weise zugeführt wird,
b) mindestens einen Übertragungszweig (70-1, ..., 70-S) für jedes Übertragungsfrequenzband, in dem ein zwischenfrequenzmoduliertes Sendesignal in das Sendefrequenzband konvertiert wird,
**dadurch gekennzeichnet, dass**
c) die Konvertierung in das Sendefrequenzband durch einen Phasenvergleich des zwischenfrequenzmodulierten Sendesignals mit einem Sendesignal, das in ein Zwischenfrequenzband zurückkonvertiert wird, und durch die Steuerung eines spannungsgesteuerten Oszillators (78-1, ..., 78-S) in Übereinstimmung mit dem Phasenunterschied erreicht wird, und
d) ein Multibandfrequenzgenerator gemäß einem der Ansprüche 1 bis 13, der ausgefertigt ist, die lokalen Oszillatorsignale zu erzeugen.

15. Eine Sende/Empfangseinheit gemäß Anspruch 14, **dadurch gekennzeichnet, dass** der Übertragungszweig für jedes Übertragungsfrequenzband beinhaltet:
a) einen Phasendetektor (74) zum Erzeugen des Frequenzunterschiedes zwischen dem zwischenfrequenzmodulierten Sendesignal und dem Sendesignal, das in die Zwischenfrequenz am Ausgang des Übertragungszweigs zurückkonvertiert wird, und
b) einen Schleifenfilter (76) zum Zuführen des Phasenunterschiedes, der durch den Phasenvergleich erzeugt wird, zu dem spannungsgesteuerten Oszillator des Übertragungszweiges.

16. Eine Sende/Empfangseinheit gemäß Anspruch 15, **dadurch gekennzeichnet, dass** der Phasendetektor und der Schleifenfilter für jeden Übertragungszweig für jeden Übertragungszweig gemeinsam sind.

17. Eine Sende/Empfangseinheit gemäß Anspruch 15, **dadurch gekennzeichnet, dass** für jeden Übertragungszweig ein Schleifenfilter (76-1, ...,76-S) vorgesehen ist.

18. Eine Sende/Empfangseinheit gemäß einem der Ansprüche 14 bis 17, **dadurch gekennzeichnet, dass** in jedem Übertragungszweig eine Multiplikationseinrichtung (82-1, ..., 82-S) vorgesehen ist, um das Ausgangssignal der verschiedenen Sendekanäle durch Multiplikation mit einem verwandten, zweiten, lokalen Oszillatorsignal zurückzukonvertieren.

19. Ein Verfahren zum Betreiben eines Multibandfrequenzgenerators, um ein Ausgangssignal in mindestens zwei Frequenzbändern zu erzeugen, das die Schritte beinhaltet:
a) Ausgabe des Ausgangssignals über eine Ausgabe eines spannungsgesteuerten Multibandoszillators (22-1, ..., 22-N) für jedes Frequenzband,
b) Ableiten eines Phasenunterschiedes zwischen einem Frequenzsteuereingangssignal und dem erzeugten Ausgangssignal in einer Frequenzsyntheseeinrichtung (10),
c) Steuerung des spannungsgesteuerten MultibandOszillators (22-1, ..., 22-N) durch Verwenden des Phasenunterschiedes als korrigierende Variable,
**dadurch gekennzeichnet, dass** dieses weiter den Schritt beinhaltet:
d) Koppeln des Ausgangssignals am Ausgangsanschluss des spannungsgesteuerten Multibandoszillators (22-1, ..., 22-N) über eine frequenzselektive Kopplungseinrichtung (24), die aus einer Filterbank besteht, die angepasst ist, ein Entkoppeln der verschiedenen Multibandausgangssignale durch ein frequenzselektives Verhalten der Filterbank vor der Rückführung zu der Frequenzsyntheseeinrichtung (10) zu erreichen.

20. Ein Verfahren gemäß Anspruch 19, **dadurch gekennzeichnet, dass** die Auswahl des Frequenzbandes durch das An- beziehungsweise das Ausschalten einer verwandten Einheit in dem spannungsgesteuerten Multibandoszillator (22-1, ..., 22-N) und weiter durch eine geeignete Definition des Frequenzsteuereingangssignals erreicht wird.

## Revendications

1. Générateur de fréquences multibande destiné à générer un signal de sortie dans au moins deux bandes de fréquences, comprenant:
a) un oscillateur multibande à commande par tension (22-1, ..., 22-N) destiné à générer un signal de sortie dans chaque bande de fréquences à une borne de sortie individuelle pour chaque bande de fréquences,
b) un moyen (10) de synthèse de fréquences destiné à dériver une différence de phase entre un signal d'entrée de commande pour la fréquence et le signal de sortie généré,
c) au moins un moyen de commande (20) pour l'oscillateur multibande à commande par tension utilisant la différence de phase générée par ledit moyen (10) de synthèse de fréquences comme variable de correction, respectivement,
**caractérisé en ce que**
d) chaque borne de sortie dudit oscillateur multibande est couplée au moyen (10) de synthèse de fréquences via un moyen de couplage (24) sélectif en fréquences se composant d'un banc de filtres adapté pour effectuer un découplage des différents signaux de sortie de l'oscillateur multibande par un fonctionnement sélectif en fréquences dudit banc de filtres avant rétroaction vers le moyen (10) de synthèse de fréquences.

2. Générateur de fréquences multibande selon la revendication 1, **caractérisé en ce que** il est prévu un moyen de commande spécialisé (20-1, ..., 20-N) pour chaque bande de fréquences.

3. Générateur de fréquences multibande selon une des revendications 1 et 2, **caractérisé, en ce que** le moyen (10) de synthèse de fréquences comprend:
e) un premier diviseur de référence programmable (12) destiné à dériver le signal d'entrée de commande en divisant la fréquence d'un signal de référence pré-spécifié,
f) un second diviseur de signal programmable (14) destiné à diviser la fréquence du signal de sortie du moyen (24) de couplage sélectif en fréquences via un facteur prédéfini, et
g) un moyen (16) détecteur de différence de phase destiné à dériver la différence de phase entre le signal de sortie du premier diviseur de référence programmable (12) et le signal de sortie du second diviseur de signal programmable (14).

4. Générateur de fréquences multibande selon une des revendications 1 ou 3, **caractérisé en ce que** le moyen de commande (20) pour l'oscillateur multibande à commande par tension est un filtre à boucle.

5. Générateur de fréquences multibande selon la revendication 2 ou 3, **caractérisé en ce que** chaque moyen de commande (20-1, ..., 20-N) pour l'oscillateur de fréquences multibande à commande par tension est un filtre à bouclè.

6. Générateur de fréquences multibande selon une des revendications 1 à 5, **caractérisé en ce que** l'oscillateur multibande à commande par tension se compose de plusieurs oscillateurs (22-1, ..., 22-N) à bande unique à commande par tension connectés en parallèle.

7. Générateur de fréquences multibande selon une des revendications 1 à 6, **caractérisé en ce que** l'oscillateur multibande à commande par tension est un oscillateur à commande par tension commutable.

8. Générateur de fréquences multibande selon une des revendications 1 à 7, **caractérisé en ce que** le banc de filtres comprend au moins un filtre passe-bas (30).

9. Générateur de fréquences multibande selon la revendication 8, **caractérisé en ce que** le banc de filtres comprend au moins un filtre passe-bande (28).

10. Générateur de fréquences multibande selon la revendication 8 ou 9, **caractérisé en ce que** le banc de filtres comprend au moins un filtre passe-haut (26).

11. Générateur de fréquences multibande selon une des revendications 8 à 10, **caractérisé en ce que** le filtre passe-bas comprend une première inductance (36) connectée en série entre la borne d'entrée du filtre passe-bas et la borne de sortie du filtre passe-bas et un premier condensateur (38) réalise une ramification vers la terre devant la première inductance (36).

12. Générateur de fréquences multibande selon la revendication 11, **caractérisé en ce que** dans le filtre passe-bas un second condensateur (40) est connecté en série entre la première inductance (36) et la borne d'entrée du filtre passe-bas.

13. Générateur de fréquences multibande selon une des revendications 10 à 12, **caractérisé en ce que** le filtre passe-haut (26) comprend un troisième condensateur (32) connecté en série entre la borne d'entrée du filtre passe-haut et la borne de sortie du filtre passe-haut et une seconde inductance (34) réalise une ramification vers la terre devant le troisième condensateur (32).

14. Unité d'émission/réception pour une unité de radio mobile avec un fonctionnement multibande, comprenant:
a) au moins une branche de réception (62-1, ..., 62-E) pour chaque bande de fréquences de réception avec un étage mélangeur, vers lequel un signal d'un premier oscillateur local est envoyé d'une manière appropriée,
b) au moins une branche d'émission (70-1, ..., 70-S) pour chaque bande de fréquences d'émission dans laquelle un signal intermédiaire d'émission modulé en fréquence est converti dans la bande de fréquences d'émission,
**caractérisée en ce que**
c) la conversion dans la bande de fréquences d'émission est effectuée par une comparaison de phase du signal intermédiaire d'émission modulé en fréquence avec un signal d'émission reconverti dans une bande de fréquences intermédiaire et par une commande d'un oscillateur (78-1, ..., 78-S) à commande par tension conformément à la différence de phase, et
d) un générateur de fréquences multibande selon une des revendications 1 à 13 est créé pour générer les signaux de l'oscillateur local.

15. Unité d'émission/réception selon la revendication 14, **caractérisée en ce que** la branche d'émission pour chaque bande de fréquences d'émission comprend :
e) un détecteur de phase (74) destiné à générer la différence de fréquences entre le signal intermédiaire d'émission modulé en fréquence et lé signal d'émission reconverti dans la fréquence intermédiaire à la sortie de la branche d'émission, et
f) un filtre à boucle (76) destiné à fournir la différence de phase générée par la comparaison de phase vers l'oscillateur à commande par tension de la branche d'émission.

16. Unité d'émission/réception selon la revendication 15, **caractérisée en ce que** le détecteur de phase et le filtre à boucle pour chaque branche d'émission sont communs à chaque branche d'émission.

17. Unité d'émission/réception selon la revendication 15, **caractérisée en ce que** il est prévu un filtre à boucle (76-1, ..., 76-S) pour chaque branche d'émission.

18. Unité d'émission/réception selon une des revendications 14 à 17, **caractérisée en ce que** il est prévu un moyen de multiplication (82-1, ..., 82-S) dans chaque branche d'émission pour reconvertir le signal de sortie des différents canaux d'émission par une multiplication avec un signal d'un second oscillateur local connexe.

19. Procédé de fonctionnement d'un générateur de fréquences multibande destiné à générer un signal de sortie dans au moins deux bandes de fréquences, comprenant les étapes consistant à :
a) sortir le signal de sortie via une sortie individuelle d'un oscillateur multibande à commande par tension (22-1, ..., 22-N) pour chaque bande de fréquences,
b) dériver une différence de phase entre un signal d'entrée de commande de fréquences et le signal de sortie généré dans un moyen (10) de synthèse de fréquences,
c) commander l'oscillateur multibande à commande par tension (22-1,..., 22-N) en utilisant la différence de phase comme variable de correction,
**caractérisé en ce que** il comprend en outre les étapes consistant à :
d) coupler le signal de sortie à la borne de sortie de l'oscillateur multibande à commande par tension (22-1, ..., 22-N) via un moyen de couplage (24) sélectif en fréquences se composant d'un banc de filtres adapté pour effectuer un découplage des différents signaux de sortie multibande par un fonctionnement sélectif en fréquences dudit banc de filtres avant rétroaction vers le moyen (10) de synthèse de fréquences.

20. Procédé selon la revendication 19, **caractérisé en ce que** la sélection de la bande de fréquences est effectuée par un enclenchement et un déclenchement, respectivement, d'une unité connexe dans l'oscillateur multibande à commande par tension (22-1, ..., 22-N) et en outre par une définition appropriée du signal d'entrée de commande des fréquences.
